# EUROPÄISCHE PATENTSCHRIFT

(11) **EP 0 843 888 B1**
(45) Veröffentlichungstag und Bekanntmachung des Hinweises auf die Patenterteilung: **04.10.2001**
(21) Anmeldenummer: 96928336.5
(22) Anmeldetag: 25.07.1996
(51) Int. Cl.: H01L 21/265

(54) **VERFAHREN ZUR HERSTELLUNG EINES SELBSTJUSTIERTEN KONTAKTES UND EINES DOTIERTEN BEREICHS**
PROCESS FOR MANUFACTURING A SELF-ALIGNED CONTACT AND DOPED REGION
PROCEDE POUR REALISER UN CONTACT AUTO-ALIGNE ET UNE REGION DOPEE

(30) Priorität: 25.07.1995 DE 19527146
(43) Veröffentlichungstag der Anmeldung: 27.05.1998
(73) Patentinhaber: Infineon Technologies AG, 81669 München (DE)
(72) Erfinder: KERBER, Martin, D-81827 München (DE)
(74) Vertreter: Zedlitz, Peter, Dipl.-Inf.
(86) Internationale Anmeldenummer: DE9601398
(87) Internationale Veröffentlichungsnummer: WO9705649

(56) Entgegenhaltungen:
- US-A- 4 232 439
- US-A- 5 512 498
- PATENT ABSTRACTS OF JAPAN vol. 018, no. 105 (E-1512), 21.Februar 1994 & JP,A,05 304169 (NEC CORP), 16.November 1993,
- PATENT ABSTRACTS OF JAPAN vol. 94, no. 010 & JP,A,06 283675 (SONY CORP), 7.Oktober 1994,
- PATENT ABSTRACTS OF JAPAN vol. 95, no. 006 & JP,A,07 153713 (NEC CORP), 16.Juni 1995,

## Beschreibung

Die Erfindung betrifft ein Verfahren zur Herstellung eines selbstjustierten Kontaktes und eines dotierten Bereichs in einem Halbleitermaterial.

Integrierte CMOS-Schaltkreise werden mit einer Vielzahl von Prozeßschritten hergestellt. Die Herstellungskosten dieser Schaltkreise werden dabei durch die Prozeßkomplexität und die physikalische Bearbeitungszeit bestimmt. Hochkomplexe Bausteine erfordern deshalb mehrere hundert einzelne Prozeßschritte bis zum fertigen Produkt und eine Vielzahl von Tagen für den Prozeßdurchlauf und die Herstellung des Produkts.

Integrierte CMOS-Schaltkreise, die auf einkristallinen Siliziumscheiben hergestellt werden, erfordern üblicherweise mindestens sieben Fototechnikschritte für den Grundprozeß zur Herstellung der Schaltkreisfunktionen in dem Silizium und fünf Fototechnikschritte für zwei Metallisierungsebenen samt Passivierung. Ein typischer Prozeß umfaßt eine erste Maske für eine selbstjustierte Wannenimplantation in dem Siliziumsubstrat mit einem nachfolgenden termischen Eintreibschritt, eine zweite Maske zur Herstellung einer Feldisolation, beispielsweise durch lokale Oxidation, eine dritte Maske zur Einstellung einer Einsatzspannung eines MOS-Transistors, wobei die Einsatzspannung eines NMOS-Transistors typischerweise ganzflächig erfolgt und die Maske dann für einen PMOS-Transistor erforderlich ist.

An die vorgenannten Schritte schließen sich eine vierte Maske für die Gatestrukturierung, eine fünfte Maske für eine niedrig dotierte Source-/Drainimplantation des NMOS-Transistors, die sogenannte LDD-Implantation, sowie eine sechste Maske für die Herstellung der hochdotierten Drain des NMOS-Transistors an. Die siebte Maske schließlich ist erforderlich für die Implantation der Drain des PMOS-Transistors.

Nach der Erzeugung ganzflächiger Isolationszwischenschichten mit Kontaktlöchern durch eine achte sind die neunte bis elfte Maske für die Metallisierung einer ersten Schicht, für die Erzeugung von Kontaktlöchern und für eine zweite Metallisierungsschicht vorgesehen. Die Metallisierungen sind üblicherweise aus Aluminium. Eine zwölfte Maske schließt sich daran an, um eine Passivierungsschicht zu erzeugen.

In Schaltkreisen, die zusätzlich noch weitere Elemente haben, beispielsweise einen Kondensator oder einen Widerstand, können weitere Masken erforderlich sein. Grundsätzlich ist es immer wünschenswert, eine möglichst geringe Anzahl von Prozeßschritten zu haben, um die Herstellungskosten und die Durchlaufzeit zu senken.

Der Erfindung liegt die Aufgabe zugrunde, ein Verfahren zur Herstellung eines selbstjustierten Kontaktes und eines dotierten Bereichs anzugeben, das eine geringere Anzahl von Prozeßschritten erfordert.

Diese Aufgabe wird mit den Merkmalen des Patentanspruchs 1 gelöst.

Der Erfindung liegt die Erkenntnis zugrunde, daß ein erheblicher Aufwand für die Herstellung von CMOS-Schaltkreisen mit einer Verringerung der Anzahl der Maskenschritte möglich ist. Durch die laufende Verbesserung der Implantationsgeräte und durch die Skalierung von Schichtdicken ist es zwar möglich, die Wannenimplantierungen nach der Herstellung der Feldisolationszonen durchzuführen. Dadurch wird der zeitaufwendige Wanneneintreibschritt eingespart. Allerdings bleibt durch die Kombination mit einer Maske zur Einstellung der PMOS-Einsatzspannung die Gesamtzahl der Masken unverändert.

Die Erfindung sieht vor, daß die notwendige Anzahl der Fototechnikschritte bzw. die Anzahl der Masken im Grundprozeß zur Herstellung eines selbstjustierten Wannen- oder Substratkontakts und einer Wanne auf eine Maske reduziert wird. Dies ist möglich, indem die für die Realisierung der Elemente notwendigen Implantationen in einem Schritt erfolgen, für den nur eine Maske erforderlich ist.

Die Erfindung hat den Vorteil, daß eine Maske eingespart werden kann. Dementsprechend wird der Gesamtprozeß weniger komplex. Die Herstellungskosten werden gegenüber modernen Prozessen deutlich verringert. Auch die physikalische Bearbeitungszeit wird deutlich verringert.

Ausgestaltungen der Erfindung sind in Unteransprüchen gekennzeichnet.

Die Erfindung wird nachfolgend anhand eines Ausführungsbeispiels näher erläutert. Es zeigen:

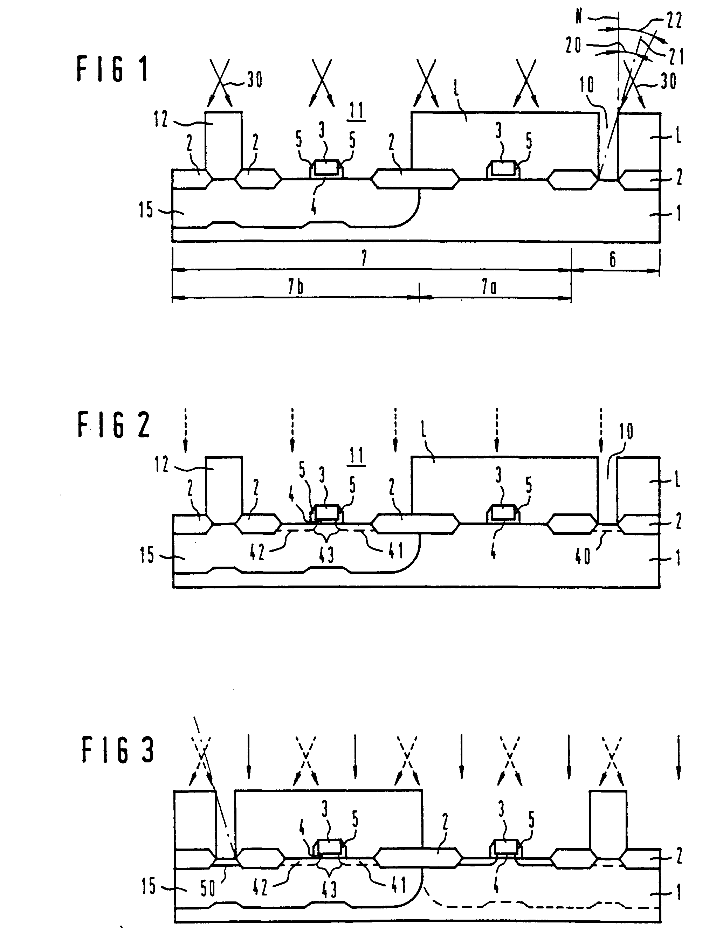

FIG 1 bis 3 schematische Querschnitte durch verschiedene Stadien des Herstellungsprozesses.

Gemäß FIG 1 beginnt der Prozeß mit der an sich bekannten Herstellung von Feldisolationszonen 2 in einem Substrat 1. Üblicherweise wird dazu zunächst eine Nitridschicht auf dem Substrat ganzflächig aufgetragen und durch eine erste Maske, die mit einer Fototechnik erzeugt wird, und einen anschließenden Atzschritt strukturiert. Daran schließt sich die Erzeugung der Feldisolationszonen, beispielsweise als Feldoxid an. Anschließend wird die Nitridschicht entfernt. Neben der konventionellen Technik mit Hilfe einer lokalen Oxidation (LOCOS) kann ein Oxid aus der Gasphase chemisch abgeschieden und strukturiert werden.

Es schließt sich die Erzeugung eines Gateoxids von typisch 15 nm Dicke sowie die Abscheidung einer Siliziumschicht an. Eine mit einer zweiten Fototechnik erzeugte zweite Maske in Verbindung mit einem weiteren Ätzschritt führt zu einer strukturierten Gateelektrode 3, die durch das Gateoxid 4 vom Substrat isoliert ist.

An die Strukturierung der Gateelektrode schließt sich typischerweise ein Oxidationsschritt an, mit dem eine Oxidschicht von 10 nm ganzflächig erzeugt wird. Darüber wird mit Hilfe eines CVD-Verfahrens (chemische Abscheidung aus der Dampfphase) eine Isolationsschicht konform abgeschieden, beispielsweise Tetraethylorthosilikat, das anschließend anisotrop rückgeätzt wird, so daß seitliche Isolationsstege 5 neben der Gateelektrode stehen bleiben. Danach wird mit einer Lackmaske ein herzustellender Transistor definiert.

In dem Ausführungsbeispiel der Figuren sei ein NMOS-Transistoren vorgesehen. Selbstverständlich können mit dem gleichen Verfahren auch PMOS-Transistoren hergestellt werden. Mit einer zweiten Lackmaske und entsprechend einem zweiten Verfahrensdurchlauf können CMOS-Transistoren hergestellt werden.

Die Maske L, im Ausführungsbeispiel als Lackmaske hergestellt, definiert einen ersten Bereich 6, in dem der selbstjustierte Kontakt herzustellen ist und einen zweiten Bereich 7, in dem der dotierte Bereich vorgesehen ist.

In dem ersten Bereich 6 enthält die Lackmaske L eine Öffnung 10 zwischen zwei Feldisolationsgebieten. Die Öffnung 10 hat ein Aspektverhältnis, d.h. ein Verhältnis von Lackhöhe zu Öffnungsbreite, welches einen Aspektwinkel 20 definiert. Der Aspektwinkel 20 sei dabei der Winkel zwischen der Diagonalen 21 von einem Fußpunkt der Öffnung 10 zu einer gegenüberliegenden oberen Kante der Lackmaske und der Normalenrichtung auf das Halbleitermaterial. Dieser Aspektwinkel 20 wird gemäß der Erfindung so gewählt, daß ein vorgegebener, auf die Maskierungsschicht gerichteter Einfallsstrahl 30 einen größeren Winkel 22 zur Normalenrichtung N auf das Halbleitermaterial einschließt als der Aspektwinkel 20. Damit wird gewährleistet, daß Einfallsstrahlen 30 nicht auf den Bodenbereich der Öffnung 10 gelangen können.

Mathematisch gesehen wird die Öffnung so erzeugt, daß ihre Längsausdehnung zwischen zwei Fußpunkten auf der Halbleiteroberfläche höchstens gleich dem Produkt aus der Diagonalen zwischen einem der Fußpunkte einerseits und einem oberen Eckpunkt der Maskenöffnung andererseits und dem Cosinus eines Einfallswinkels zur Normalenrichtung N ist.

Im Bereich 7 ist die Lackmaske L so strukturiert, daß ein in der FIG. 1 rechtsliegender Bereich 7a von der Lackmaske vollständig überdeckt ist. In diesem Bereich können beispielsweise durch die vorausgegangenen Prozeßschritte Feldisolationsund Gate-Strukturen 2 bis 5 erzeugt sein, die für einen in späteren Verfahrensschritten zu erzeugenden PMOS-Transistor vorgesehen sind. Im Bereich 7b, der für einen im Ausführungsbeispiels vorgesehenen NMOS-Transistor vorgesehen ist, enthält die Lackmaske L eine Öffnung zwischen zwei Feldisolationsgebieten, die einer Gateelektrodenstruktur im Abstand benachbart sind. Die Öffnung 11 wird einseitig durch einen Maskensteg 12 begrenzt, der zwischen zwei Feldisolationsgebieten im Bereich des für den NMOS-Transistors vorgesehenen Wannenkontaktes angeordnet ist. Es ist vorgesehen, daß der Maskensteg 12 zwei Feldisolationskanten sicher überlappt.

Der Erfindung liegt nun die Erkenntnis zugrunde, daß Gräben und Löcher wie die Öffnung 10 gemäß FIG 1 mit einem gewissen minimalen Aspektverhältnis für schräge Implantierungen nahezu vollständig maskierend wirken, während Stege und Säulen, wie der Maskensteg 12, derartige Implantierungen nur unwesentlich maskieren.

Gemäß FIG 1 wird im Anschluß an die Herstellung der Lackmaske L mit den beschriebenen Öffnungen bzw. Stegen 10 bis 12 eine schräge Implantation durchgeführt, wobei der Implantationswinkel dem Winkel 20 des Richtungsstrahls 30 entspricht und z. B. 25 Grad beträgt. Diese Implantation ist für einen Wannenbereich, d.h. den dotierten Bereich in dem zweiten Bereich 7 bzw. genauer 7b vorgesehen. Dazu werden Atome mit p-Leitfähigkeit, also z. B. Borionen mit einer Energie im Bereich von über 100 bis einige 100 keV, typisch 230 keV und einer Atomkonzentration von typisch 10¹³ implantiert. Als Implantationswinkel 22 können beispielsweise 25° vorgesehen sein.

Im Bereich 7b wirken die nicht durch die Maske abgedeckten Feldisolationsgebiete 2, die Gateelektrodenstruktur und der Maskensteg 12 gegenüber der Implanation nicht oder schwach maskierend, so daß eine tiefe Implantation einer p-Wanne 15 möglich ist. Die implantierten Atome gehen dabei in den Feldisolationsgebieten und der Gateelektrodenstruktur durch diese Gebiete hindurch in das Halbleitersubstrat, um die Wanne 15 zu formen.

In Vorversuchen hat sich herausgestellt, daß die Gateelektrodenstruktur und insbesondere das Gateoxid bei einer derartigen Implantation nicht oder nur so schwach beeinträchtigt werden, daß die spätere Transistorfunktion vollständig erhalten bleibt. Im Bereich des Lacksteges dringen die implantierten Ionen neben dem Steg in das Halbleitermaterial ein, so daß aufgrund der noch vorhandenen Restmaskierung des Maskenstegs 12 eine unscharfe Kontur im Wannenbereich entsteht. Diese Kontur reicht jedoch vollständig aus, um eine Wanne entsprechend gegebener Spezifikationen herzustellen.

Gemäß FIG 2 wird anschließend der selbstjustierte Kontakt 40 hergestellt, der gleichzeitig mit Source-/Drainzonen 41 und 42 für den Transistor erzeugt wird. Dazu wird ein n-dotierendes Material in nahezu senkrechter Weise in die vorgegebene Struktur implantiert. Im Ausführungsbeispiel gemäß FIG 2 ist eine Implantation von Arsen mit einer typischen Energie von etwa 40 keV und einer Konzentration von typisch 5 · 10¹⁵ Atomen vorgesehen. Im Bereich der Öffnung 10 entsteht dabei der hochdotierte Kontaktbereich 40 zwischen den zwei angrenzenden Feldisolationsgebieten, da in diesem Fall die Öffnung 10 der Maske L nicht maskierend wirkt. Im Bereich 7b bzw. der Öffnung 11 werden Source-/Drain-Zonen 41 und 42 erzeugt, die bei der gegebenen Implantationsenergie und Implantationsdosis durch die Isolationsstege 5 an der Gateelektrode 3 und die beidseitig von der Gateelektrodenstruktur liegenden Feldisolationsgebiete maskiert werden. Es entstehen deshalb selbstjustierte Kontakte 41 und 42.

Zu erwähnen ist, daß nach der Wannenimplantation eine zweite Implantation von p-dotierenden Atomen, d.h. Boratomen mit erheblich niedriegerer Energie als für die Wannenherstellung erfolgen kann. Mit dieser zweiten Bor-Implantation, die typischerweise bei 60 keV mit einer Dosis von 4 · 10¹² Atomen erfolgt, werden im Transistorbereich der Öffnung 11 die Einsatzspannung und die Durchbruchsfestigkeit des Transistors eingestellt. Die Implantationsenergie ist so zu wählen, daß die Reichweite der Borionen größer aber nicht wesentlich größer als die Dicke der Gateelektrode ist.

Gemäß FIG 3 kann nach der Herstellung der Source-/Drain-Zonen sowie des selbstjustierten Kontaktes eine weitere schräge Implantation erfolgen, die in diesem Fall so gewählt wird, daß der Einfallswinkel der Implantationsrichtung größer ist als der Aspektwinkel 20. Diese Implantation erfolgt mit Phosphoratomen bei einer typischen Energie von 80 keV und einer Dosis von 3 · 10¹³ Atomen. Die Implantation dient zur Erzeugung niedrig dotierter n-leitfähiger Zonen insbesondere im Zwischenbereich zwischen der Source-/Drain-Zone und der Kante der Gateelektrode 3. Diese Gebiete werden auch als LDD-Zonen (Lightly Doped Drain) bezeichnet.

Im Bereich des selbstjustierten Kontaktes wirkt die Öffnung 10 der Maske L für schräge Implantationen maskierend. Alternativ zur Schrägimplantation der LDD-Zonen gemäß FIG 3 kann eine nahezu senkrechte Implantation vorgesehen sein. Dazu ist es jedoch erforderlich, vor der Implantation die Isolationsstege 5 neben der Gateelektrode durch eine isotrope Ätzung zu entfernen. Es ist unproblematisch, daß auch im Bereich des selbstjustierten Kontaktes 40 LDD-Zonen im Umfeld des Kontaktes entstehen.

Wie geschildert, folgen die Implantationen der n-leitfähigen Atome aufgrund der niedrigen verwendeten Energie und des gewählten kleinen bzw. senkrechten Implantationswinkels im wesentlichen den Masken- bzw. Feldisolationsflanken. Durch das Layout und das Aspektverhältnis der Maske ist es möglich, eine tiefe Wannenimplantation zu maskieren und mit derselben Maske eine flache Source-/Drain- bzw. Kontaktimplantation anzubringen, wobei der Kontakt 40 als Substratkontakt oder aber als Wannenkontakt für eine in nachfolgenden Prozeßschritten herzustellende Wanne dient. Mit den Maskenstegen 12 erzielt man einen umgekehrten Effekt, d.h. die flache Source/Drain-Implantation wird maskiert, während die tiefe Wannenimplantation nicht oder nur gering maskiert wird.

In einem Ausführungsbeispiel, in dem nachfolgend an die Herstellung des geschilderten NMOS-Transistors ein PMOS-Transistor oder ein derartiger Transistor allein hergestellt werden soll, wird im Anschluß an die Implantationsschritte gemäß FIG 1 bis 3 die Maske L entfernt und eine zweite Maske aufgebracht, die derart strukturiert wird, daß im Bereich des Maskenstegs 12 eine der Öffnung 10 entsprechende Öffnung vorgesehen ist, daß der Bereich der Öffnung 11 maskiert ist, während der Bereich 7a unmaskiert bleibt. Im Bereich der gemäß FIG 1 bis 3 vorgesehenen Öffnung 8 wird ein Maskensteg vorgesehen, der die Kanten der an den Kontakt 40 angrenzenden Feldisolationszonen sicher überdeckt. Es schließen sich ähnlich Implantationsschritte mit ähnlichen Implantationswinkeln an, wie anhand der FIG 1 bis 3 erläutert, mit dem Unterschied jedoch, daß anstelle von p-dotierenden Atomen nunmehr n-dotierende Atome implantiert werden und umgekehrt. Beispielsweise wird für die Wannenimplantation Phosphor mit einer Energie von typisch 500 keV und einer Dosis von 1 · 10¹³ Atomen unter 25° implantiert. Es kann sich eine Phosphorimplantation zur Einstellung der Durchbruchfestigkeit von typisch 230 keV und einer Dosis von 1,0 · 10¹² Atomen und eine Borimplantation zur Einstellung der PMOS-Einsatzspannung von typisch 60 keV, 3.0 · 10¹² Atomen anschließen. Danach werden die Source-/Drain-Zonen und der Wannenkontakt für die Wanne 15 durch eine Implantation von Bor von typisch 10 keV und 5 · 10¹⁵ Atomen erzeugt.

## Patentansprüche

1. Verfahren zur Herstellung eines selbstjustierten Kontakts und eines dotierten Bereichs in einem Halbleitermaterial,
- bei dem eine Maskierungsschicht auf dem Halbleitermaterial aufgebracht und derart strukturiert wird, daß
• in einem ersten Bereich (6), in dem der Kontakt (40) vorgesehen ist, eine Öffnung (10) mit einem Aspektverhältnis so gebildet wird, daß der Aspektwinkel (20) zwischen einer Diagonalen (21) und der Normalen (N) auf das Halbleitermaterial (1) kleiner ist als ein auf die Maskierungsschicht (L) gerichteter Einfallswinkel (22), und
• in einem zweiten Bereich (7b) in dem der dotierte Bereich (15) vorgesehen ist, ein Steg (12) der Maskierungsschicht verbleibt,
- bei dem der dotierte Bereich durch eine schräge Implantation (30) von Atomen eines ersten Leitfähigkeitstyps unter dem Einfallswinkel (22) als Implantationswinkel erzeugt wird,
- bei dem der Kontakt (40) durch eine im wesentlichen senkrechte Implantation von Atomen eines zweiten Leitfähigkeitstyps hergestellt wird, und
- bei dem vor der Maskierungsschicht (L) Feldisolationsgebiete (2) und eine strukturierte Gateelektrode (3) auf einem Gateoxid (4) hergestellt werden.

2. Verfahren nach Anspruch 1,
**dadurch gekennzeichnet,**
**daß** der Steg (12) der Maskierungsschicht die Kanten zweier angrenzender Isolationsgebiete überlappt.

3. Verfahren nach Anspruch 1 oder 2,
**dadurch gekennzeichnet,**
**daß** eine zweite Lackmaske aufgebracht und strukturiert wird, so daß im zuvor durch den Steg (12) abgedeckten Bereich (50) eine Öffnung mit dem Aspektverhältnis (20) und der zuvor geöffnete Bereich (10) durch eine die angrenzenden Feldoxidbereiche sicher umfassende Maske abgedeckt ist,
- bei dem ein implantierter Bereich durch schräge Implantation von Atomen des zweiten Leitfähigkeitstyps unter dem Einfallswinkel (22) als Implantationswinkel erzeugt wird, und
- bei dem der Kontakt (50) durch eine im wesentlichen senkrechte Implantation von Atomen des ersten Leitfähigkeitstyps hergestellt wird.

## Claims

1. Method for producing a self-aligned contact and a doped region in a semiconductor material,
- in which a masking layer is applied to the semiconductor material and structured in such a way that
• in a first region (6), in which the contact (40) is provided, an opening (10) having an aspect ratio is formed such that the aspect angle (20) between a diagonal (21) and the normal (N) to the semiconductor material (1) is less than an angle of incidence (22) directed at the masking layer (L), and
• in a second region (7b), in which the doped region (15) is provided, a web (12) of the masking layer remains,
- in which the doped region is produced by inclined implantation (30) of atoms of a first conductivity type at the angle of incidence (22) as implantation angle,
- in which the contact (40) is produced by essentially perpendicular implantation of atoms of a second conductivity type, and
- in which field insulation regions (2) and a structured gate electrode (3) on a gate oxide (4) are produced before the masking layer (L).

2. Method according to Claim 1,
**characterized in that** the web (12) of the masking layer overlaps the edges of two adjoining insulation regions.

3. Method according to Claim 1 or 2,
**characterized in that** a second resist mask is applied and structured, with the result that in the region (50) previously covered, by the web (12), an opening having the aspect ratio (20) is formed, and the previously open region (10) is covered by a mask that reliably encompasses the adjoining field oxide regions,
- in which an implanted region is produced by inclined implantation of atoms of the second conductivity type at the angle of incidence (22) as implantation angle, and
- in which the contact (50) is produced by essentially perpendicular implantation of atoms of the first conductivity type.

## Revendications

1. Procédé de fabrication d'un contact autoaligné et d'une zone dopée dans un matériau semiconducteur,
- dans lequel on dépose une couche de masquage sur le matériau semiconducteur et on la structure de façon que
• dans une première zone (6) dans laquelle est prévu le contact (40), il est formé une ouverture (10) ayant un rapport d'aspect tel que l'angle (20) d'aspect entre une diagonale (21) et la normale (N) au matériau (1) semiconducteur est plus petit qu'un angle (22) d'incidence dirigé sur la couche (L) de masquage, et
• dans une deuxième zone (7b) dans laquelle est prévue la zone (15) dopée, il subsiste une nervure (12) de la couche de masquage,
- dans lequel la zone dopée est produite par une implantation (30) inclinée d'atome d'un premier type de conductivité sous l'angle (22) d'incidence servant d'angle d'implantation,
- dans lequel le contact (40) est obtenu par une implantation sensiblement verticale d'atome d'un deuxième type de conductivité, et
- dans lequel on fabrique, avant la couche (L) de masquage des zones (2) à isolement de champ et une électrode (3) de grille structurée sur un oxyde (4) de grille.

2. Procédé suivant la revendication 1, **caractérisé en ce que** la nervure (12) de la couche de masquage chevauche les bords de deux zones d'isolement adjacentes.

3. Procédé suivant la revendication 1 ou 2, **caractérisé en ce que** l'on dépose sur les structures un deuxième masque à vernis, de sorte que dans là zone (50) recouverte à l'avance par la nervure (12), une ouverture ayant le rapport (20) d'aspect est recouverte d'une manière sûre par le masque, et la zone (10) ouverte, à l'avance est recouverte d'une manière sûre par une zone d'oxyde de champ adjacente,
- dans lequel une zone implantée implantation inclinée d'atome dû deuxième type de conductivité est produite en utilisant l'angle (22) d'incidence comme angle d'implantation, et
- dans lequel le contact (50) est obtenu par une implantation sensiblement verticale d'atome du premier type de conductivité.
